# EUROPÄISCHE PATENTANMELDUNG

(11) **EP 1 498 957 A1**
(43) Veröffentlichungstag der Anmeldung: **19.01.2005**
(21) Anmeldenummer: 03015994.1
(22) Anmeldetag: 14.07.2003
(51) Int. Cl.: H01L 29/786, H01L 51/20

(54) **Feldeffekttransistor und Verfahren zum Herstellen eines Feldeffekttransistors**

(71) Anmelder: Fraunhofer-Gesellschaft zur Förderung der angewandten Forschung e.V., 80686 München (DE)
(72) Erfinder: Amelung, Jörg, Dipl-Phys., 01099 Dresden (DE); Wedel, Armin, Dr.rer.nat., 14513 Teltow (DE); Todt, Ulrich, Dr.rer.nat., 01468 Moritzburg (DE)
(74) Vertreter: Schoppe, Fritz, Dipl.-Ing.

(57) **Zusammenfassung**

Ein Feldeffekttransistor umfaßt ein Substrat (10) mit einer Hauptoberfläche (10a), eine Drainschicht (16) und eine Sourceschicht (12), die sich in Richtung der Hauptoberfläche (10a) des Substrats erstrecken und übereinander angeordnet sind, und eine isolierende Schicht (14), die sich zwischen der Drainschicht (16) und der Sourceschicht (12) erstreckt. Der Feldeffekttransistor umfaßt ferner eine Kanalschicht (20), die sich auf einer seitlichen Begrenzungsfläche (14a) der isolierenden Schicht (14) erstreckt und mit der Drainschicht (16) und der Sourceschicht (12) verbunden ist. Ferner ist eine Gateisolatorschicht (24), die sich auf der Kanalschicht (20) erstreckt, und eine auf der Gateisolatorschicht (24) angeordnete Gateschicht (26) vorgesehen.

## Beschreibung

Die vorliegende Erfindung bezieht sich auf Feldeffekttransistoren und Verfahren zum Herstellen von Feldeffekttransistoren.

Für die Herstellung von Feldeffekttransistoren werden im Stand der Technik verschiedene Verfahren verwendet, die typischerweise jeweils auf bestimmte Anforderungen, wie beispielsweise einer kostengünstigen Herstellung, angepaßt sind. Im Stand der Technik ist es beispielsweise innerhalb von siliziumbasierten CMOS-Prozessen bekannt, die Gateisolatorschicht zu erzeugen, bevor die Gateelektrode aufgebracht wird, um die erforderlichen Hochtemperaturprozesse am Anfang des Herstellungsprozesses durchführen zu können. Bei der herkömmlichen Si-CMOS-Technologie stellt die Gateoxidation neben der Wannendiffusion diejenigen Prozesse dar, bei denen die höchsten im Prozeß vorkommenden Temperaturen, d. h. etwa 950°C, auftreten. Alle nachfolgenden Schritte würden durch diese Prozeßtemperaturen beeinflußt oder unmöglich, so daß es bei diesen Technologien zwingend erforderlich ist, die Gateoxidation am Anfang des Prozesses durchzuführen.

Ferner ist im Stand der Technik eine TFT-Herstellung bekannt, bei der zur Verminderung der Prozeßtemperaturen Niedertemperaturoxide verwendet werden, so daß eine umgekehrte Prozeßführung möglich wird, welche als Bottom-Gate-Technologie bezeichnet wird. Dabei wird das Gate als erstes aufgebracht, gefolgt von der isolierenden Niedertemperaturschicht und der Drain-Source-Elektroden.

Ein in zunehmendem Maße an Bedeutung gewinnendes Gebiet bei der Herstellung von Schaltungen stellen die Transistoren auf der Basis organischer Halbleiter dar. Organische Feldeffekttransistoren und Schaltungen auf Basis organischer halbleitender Substanzen (OFETs) umfassen beispielsweise niedermolekulare Aufdampfstoffe oder Polymere, die sich aus einer Lösung verarbeiten lassen, als halbleitende Substanzen. Schaltkreise auf Basis organischer Halbleiter bilden die Basis für Massenprodukte in verschiedenen Niedrig-Kosten-Anwendungsbereichen, beispielsweise der Logistik. Hierbei handelt es sich um Anwendungsbereiche, bei denen die Transistoranzahl typischerweise gering ist. Bei diesen Anwendungen ist eine Niedrig-Kosten-Herstellungstechnologie notwendig, da bestehende siliziumbasierende Herstellungsverfahren zu teuer sind.

Die oben beschriebene Bottom-Gate-Technologie wird bevorzugt auch bei organischen Transistoren verwendet, da das empfindliche organische Halbleitermaterial nicht durch die Elektrodendeposition beeinflußt wird. Zur Strukturierung der Halbleiterelemente werden neben lithographischen Verfahren auch Druckverfahren angewandt. Durch diese neuartige Strukturierungstechnologie können die Herstellungskosten der Schaltkreise gesenkt werden, so daß durch derartige Systeme elektronische Anwendungen völlig neue, vom Silizium aus Kostengründen nicht erreichbare Marktsegmente erschließen. Typische Vertreter dieser sogenannten "Wegwerfelektronik" (disposable electronics) sind Smart Labels, Tags, elektronische Etiketten und Tickets, aber auch Einwegsensoren. Für solche Produkte benötigt man bei gleichzeitig reduzierten elektronischen Anforderungen die Fähigkeit zur Integration in beliebig geformte Oberflächen und unterschiedliche Materialien bei vernachlässigbaren Kosten.

Ein Nachteil der Strukturierung mittels Druckverfahren ist jedoch, daß die Transistoreigenschaften aufgrund der großen Schwankungen der Strukturabmessungen und einer Beeinflußung der Grenzflächen stark beeinflußt werden. Die Transistoreigenschaften hängen neben den Materialien stark von den Grenzflächeneigenschaften zwischen dem Gateisolator und dem Halbleitermaterial sowie der Dimensionierung der Kanallänge ab. Eine Strukturierung der Drain-Source-Elektroden sollte daher optimalerweise die höchste Strukturtreue innerhalb des Prozesses haben und gleichzeitig bei der Strukturierung nicht die Qualität der Grenzflächen beeinflussen. Im Stand der Technik wird eine solche Strukturierung lediglich durch photolithographische Verfahren erreicht, wobei die dabei erreichten Strukturbreiten zwischen Source und Drain sich im Bereich von 10 - 20 µm bewegen. Ferner sind bereits Strukturbreiten von 5 µm erreicht wurden.

Ferner sollte bezüglich der Transistoreigenschaften nicht nur die minimale Strukturbreite in Betracht gezogen werden, sondern zusätzlich die Variation der Strukturbreite. Die Variation äußert sich direkt in der Instabilität der Kanallänge der realisierten Transistoren, so daß die Transistorparameter nicht vorhergesagt werden können. Lithographische Verfahren, die eine hohe Strukturauflösung aufweisen, können ein genaues Einstellen der Strukturbreite mit relativ geringen Abweichungen erreichen, sie sind jedoch aufgrund des sehr hohen technischen Einsatzes, insbesondere bei geringen Strukturbreiten, sehr teuer, so daß eine preiswerte Herstellung von Feldeffekttransistoren, die insbesondere auf dem Gebiet der Feldeffekttransistoren mit organisch halbleitenden Substanzen zu fordern ist, nicht möglich.

Im Stand der Technik ist es somit nicht möglich, eine Strukturierung von Transistoren mit guten und reproduzierbaren Transistoreigenschaften zu erreichen, deren Kosten gering sind und die sich insbesondere für die Herstellung von kostengünstigen "Wegwerf-Elektronikprodukten" eignet.

Die Aufgabe der vorliegenden Erfindung besteht darin, eine kostengünstige Herstellung von Feldeffekttransistoren zu schaffen.

Diese Aufgabe wird durch einen Feldeffekttransistor gemäß Anspruch 1 und ein Verfahren zum Herstellen eines Feldeffekttransistors gemäß Anspruch 9 gelöst.

Die vorliegende Erfindung schafft einen Feldeffekttransistor mit folgenden Merkmalen:
einem Substrat mit einer Hauptoberfläche;
einer Drainschicht und einer Sourceschicht, die sich in Richtung der Hauptoberfläche des Substrats erstrecken und übereinander angeordnet sind;
einer isolierenden Schicht, die sich zwischen der Drainschicht und der Sourceschicht erstreckt;
einer Kanalschicht, die sich auf einer seitlichen Begrenzungsfläche der isolierenden Schicht erstreckt und mit der Drainschicht und der Sourceschicht verbunden ist;
einer Gateisolatorschicht, die sich auf der Kanalschicht erstreckt; und
einer auf der Gateisolatorschicht angeordneten Gateschicht.

Die vorliegende Erfindung schafft ferner ein Verfahren zum Herstellen eines Feldeffekttransistors mit folgenden Schritten:
Bereitstellen eines Substrats mit einer Hauptoberfläche;
Erzeugen einer Drainschicht, einer Sourceschicht und einer isolierenden Schicht, derart, daß sich die Drainschicht und die Sourceschicht in Richtung der Hauptoberfläche des Substrats erstrecken und übereinander angeordnet sind, und sich die isolierende Schicht zwischen der Drainschicht und der Sourceschicht erstreckt;
Erzeugen einer Kanalschicht, die sich auf einer seitlichen Begrenzungsfläche der isolierenden Schicht erstreckt und mit der Drainschicht und der Sourceschicht verbunden ist;
Erzeugen einer Gateisolatorschicht, die sich auf der Kanalschicht erstreckt; und
Erzeugen einer auf der Gateisolatorschicht angeordneten Gateschicht.

Die vorliegende Erfindung basiert auf der Erkenntnis, daß von der im Stand der Technik verwendeten lateralen Strukturierung Abstand genommen werden muß, um einen kostengünstigen Feldeffekttransistor mit einer hohen Strukturgenauigkeit zu erreichen. Gemäß der Erfindung wird eine verbesserte Kanaldimensionierung des Transistors dadurch erreicht, daß die Source- und Drainschicht vertikal bezüglich des Substrats übereinander aufgebracht werden, wobei zwischen denselben eine isolierende Schicht vorgesehen ist, deren Schichtdicke die Kanaldimensionierung des Transistors festlegt. Gemäß der Erfindung erstreckt sich die Kanalschicht des Feldeffekttransistors dabei auf einer seitlichen Begrenzungsfläche der isolierenden Schicht, so daß die Kanallänge durch die Schichtdicke der isolierenden Schicht bestimmt wird.

Da sich Schichtdicken mit einer sehr hohen Genauigkeit einstellen lassen, kann mit dem erfindungsgemäßen Verfahren erreicht werden, daß die Kanallänge des Feldeffekttransistors eine hohe Genauigkeit aufweist, wodurch die Transistorparameter mit einer hohen Genauigkeit festgelegt werden können. Ferner wird es bei dem erfindungsgemäßen Verfahren möglich, sehr geringe Kanallängen einzustellen, da selbst das Erzeugen von sehr dünnen Schichten mit einfachen Mitteln sehr genau kontrolliert werden kann, beispielsweise durch eine gesteuerte Abscheidung einer Schicht mit einer entsprechenden Dicke oder ein gesteuertes Ätzen der Schichten.

Durch die Minimierung der Schichtdicke der isolierenden Schicht ist es möglich, Transistorkanallängen zu erreichen, die beispielsweise bisher noch nicht bei organischen Transistoren erreicht wurden. Da die Stromfähigkeit des Transistors umgekehrt proportional zur Kanallänge ist, kann somit die Fläche bestehender Schaltungen beträchtlich vermindert werden. Somit läßt sich durch das erfindungsgemäße Verfahren ein Feldeffekttransistor mit hervorragenden Transistorparametern in einer kostengünstigen Weise mit einer hohen Dichte auf einem Substrat erzeugen. Ferner wird durch die Verringerung der Transistorkanallängen eine Performanceverbesserung des Transistors erreicht.

Das erfindungsgemäße Verfahren ermöglicht eine kostengünstige Herstellung, da einfache und kostengünstige Strukturierungsverfahren, wie beispielsweise ein Siebdruckverfahren, angewandt werden können, ohne die Eigenschaften der Transistoren herabzusetzen, da weder eine Strukturauflösung noch eine Justage die Eigenschaften der Transistoren stark beeinflussen. Die Eigenschaften der Transistoren, d. h. insbesondere die Kanallänge, wird lediglich durch die Schichtdicke der isolierenden Schicht festgelegt, so daß das laterale Strukturieren selbst bei einer hohen Ungenauigkeit und großen Schwankungen der Strukturen die Transistorparameter nicht beeinflussen. Damit ist die Fertigung eines elektronischen Schaltkreises ohne kritische Lithographieschritte möglich, da die Kanaldimensionierung des Transistors durch die abgeschiedene Schichtdicke erreicht wird.

Auf der Basis der erfindungsgemäßen Transistorstruktur ist somit die Herstellung von Schaltkreisen mit kostengünstigen Strukturierungstechnologie möglich, ohne daß die Strukturauflösung die Definition der Transistoreigenschaften begrenzt.

Bei einem Ausführungsbeispiel erstreckt sich die Kanalschicht vertikal bezüglich der Hauptoberfläche des Substrats, so daß die Kanallänge der Schichtdicke der zwischen der Sourceschicht und der Drainschicht angeordneten isolierenden Schicht entspricht. Das vertikale Anordnen der Kanalschicht weist den Vorteil auf, daß eine Dehnung des Substrats die Kanallänge des Transistors nicht verändert. Dadurch können bei einem dünn ausgebildeten Substrat, das beispielsweise vorgesehen ist, um an eine gewölbte Oberfläche angebracht zu werden, die Transistoreigenschaften, die vor allem durch die Kanallänge beeinflußt werden, im wesentlichen beibehalten werden. Dadurch eignet sich dieses Ausführungsbeispiel insbesondere für flexible und biegbare Schaltungsanordnungen.

Bei einem Ausführungsbeispiel ist es ferner vorgesehen, die seitliche Begrenzungsfläche mit einem vorbestimmten Winkel bezüglich der Hauptoberfläche zu erzeugen, so daß eine Kanallänge des Feldeffekttransistors mittels der Neigung der seitlichen Begrenzungsfläche eingestellt werden kann. Dies ermöglicht es, unter Aufbringung lediglich einer isolierenden Schicht mit einer bestimmten Dicke durch die Variation des Neigungswinkels der seitlichen Begrenzungsfläche verschiedene Feldeffekttransistoren mit unterschiedlichen Kanallängen zu erzeugen. Der Neigungswinkel kann dabei beispielsweise über ein anisotropes Ätzen eingestellt werden.

Vorzugsweise sind die übereinander angeordneten seitlichen Begrenzungsflächen der Drainschicht, der Sourceschicht und der isolierenden Schicht jeweils bündig, so daß sich eine glatte Seitenoberfläche ohne Kanten und Vorsprünge ergibt. Dies ermöglicht, daß die Kanalschicht mit einer guten Haftung aufgebracht werden kann. Die durch die Drainschicht, Sourceschicht und isolierende Schicht definierte gesamte Seitenbegrenzungsfläche kann, wie oben erläutert, vertikal bezüglich der Hauptoberfläche des Substrats ausgerichtet sein oder bezüglich derselben geneigt sein.

Bei einem Ausführungsbeispiel ist die Kanalschicht mit der isolierenden Schicht lediglich über die seitlichen Begrenzungsfläche der isolierenden Schicht verbunden und mit der Drain- und Sourceschicht lediglich über die jeweiligen seitlichen Begrenzungsflächen derselben verbunden. Es ist jedoch auch möglich, die Drainschicht und/oder die Sourceschicht über eine ihrer Hauptoberflächen mit der Kanalschicht zu verbinden.

Vorzugsweise wird das erfinderische Konzept zum Herstellen von Feldeffekttransistoren mit einer Kanalschicht aus einem organischen Halbleitermaterial verwendet, da sich das Verfahren aufgrund der geringen Herstellungskosten ideal für die Anwendung in Niedrig-Kosten-Anwendungsbereichen von Schaltkreisen auf der Basis organischer Halbleiter, beispielsweise für Massenprodukte in einer Wegwerfelektronik, eignet.

Als Materialien für die Kanalschicht aus einem organischen Halbleiter werden vorzugsweise niedermolekulare Aufdampfstoffe oder Polymere, die sich aus einer Lösung verarbeiten lassen, eingesetzt. Beispielsweise kann der Halbleiter Polythiophen aufweisen. Die isolierende Schicht, die die Kanallänge festlegt, kann beispielsweise BCB, Polyvinylphenol oder Polyimide umfassen. Die Source- und Drainschicht kann eine metallische Schicht, die beispielsweise Gold, Aluminium oder Silber aufweist, oder leitende Polymere, wie beispielsweise Polyanilin, umfassen, wodurch der Feldeffekttransistor noch kostengünstiger wird.

Die Gateisolatorschicht kann beispielsweise ebenfalls aus einem organischen Material, wie beispielsweise Polyvinylphenol oder BCB, gebildet werden. Die Gateelektrode kann aus einem leitenden anorganischen oder organischen Material sein, beispielsweise Gold, Silber oder Aluminium.

Bei dem Herstellungsverfahren des erfindungsgemäßen Transistors werden die Schichten vorzugsweise mit einem Druckverfahren aufgebracht, um eine kostengünstige Herstellung der Struktur zu erreichen. Zur Strukturierung der Gatefläche kann ein reaktives Ionenätzen mittels einer Schattenmaske eingesetzt werden.

Vorzugsweise werden bei der Herstellung alle Schichten strukturiert abgeschieden, wobei die kostengünstigen Strukturierungsverfahren, wie beispielsweise Drucktechnologien, z. B. Siebdruckverfahren, einsetzbar sind, da die Transistorparameter durch die Auflösung oder Justagegenauigkeit der Strukturierungstechnologie nicht oder nur in sehr geringem Umfang beeinflußt wird.

Das erfindungsgemäße Verfahren eignet sich ferner besonders zur Herstellung von kostengünstigen organischen Feldeffekttransistoren, da die organischen Halbleitermaterialien und die isolierende Schicht zwischen der Sourceschicht und der Drainschicht mittels eines Druckverfahrens aufgebracht werden können.

Bevorzugte Ausführungsbeispiele der vorliegenden Erfindung werden nachfolgend Bezug nehmend auf die beiliegenden Zeichnungen näher erläutert. Es zeigen:
- Fig. 1: eine schematische Querschnittsdarstellung eines Ausführungsbeispiels der vorliegenden Erfindung; und
- Fig. 2: eine schematische Querschnittsdarstellung während eines Herstellungsprozesses zum Herstellen des Feldeffekttransistors gemäß Fig. 1.

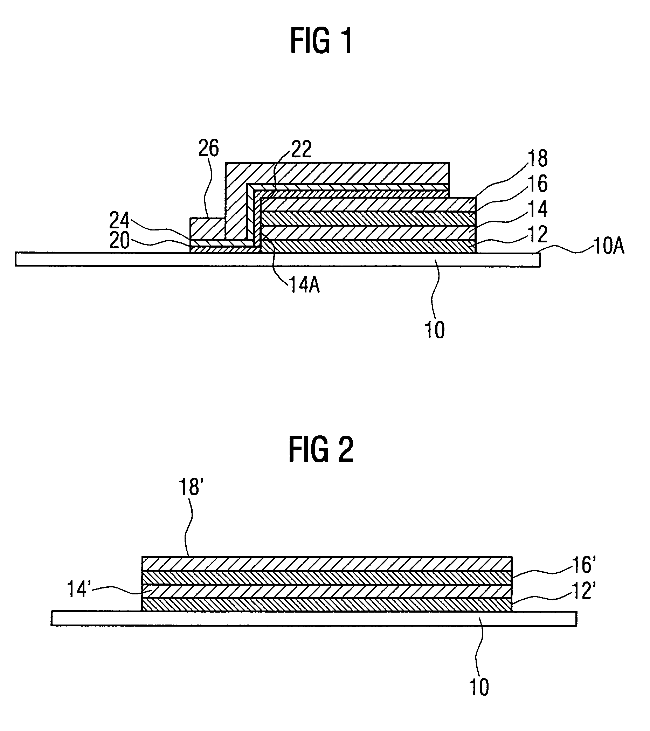

Fig. 1 zeigt als ein Ausführungsbeispiel der vorliegenden Erfindung einen Feldeffekttransistor, bei dem auf einer Oberfläche 10a eines Substrats 10 eine erste Elektrodenschicht 12 gebildet ist. Bei dem Substrat 10 kann es sich um jedes bekannte Substrat, d. h. beispielsweise ein Halbleitersubstrat, ein anorganisches Substrat oder ein organisches Substrat, handeln. Das Substrat kann auch aus mehreren miteinander verbundenen Substratschichten bestehen. Bei einem Ausführungsbeispiel, bei dem der Feldeffekttransistor vorgesehen ist, um als Schaltungselement eines sogenannten Smart Label verwendet zu werden, kann das Substrat eine geringe Schichtdicke aufweisen, die beispielsweise durch ein nachträgliches Dünnen des Substrats nach dem Fertigstellen des Feldeffekttransistors erreicht wird.

Auf dem Substrat ist eine strukturierte erste Elektrodenschicht 12 angeordnet, die beispielsweise durch ein Auflaminieren einer strukturierten Goldschicht, Aluminium oder Silberschicht gebildet wird. Die erste Elektrodenschicht stellt je nach Layout des Feldeffekttransistors entweder die Sourceschicht oder die Drainschicht dar. Über der ersten Elektrodenschicht 12 ist eine isolierende Schicht 14 angeordnet, über der wiederum eine zweite Elektrodenschicht 16 aufgebracht ist. Die zweite Elektrodenschicht 16 ist je nach Verwendung der ersten Elektrodenschicht 12 entweder eine Drainschicht oder eine Sourceschicht. Bei dem gezeigten Ausführungsbeispiel ist die erste Elektrodenschicht 12 als die Sourceschicht, d. h. die Sourceelektrode, ausgebildet, während die zweite Elektrodenschicht als die Drainschicht, d. h. die Drainelektrode, ausgebildet ist.

Wie es in Fig. 2 zu erkennen ist, erstrecken sich die erste und zweite Elektrodenschicht und die isolierende Schicht 14 in Richtung der Hauptoberfläche des Substrats 10, wobei die isolierende Schicht 14 mit ihrer unteren Hauptoberfläche die erste Elektrodenschicht berührt, während die obere Hauptoberfläche der isolierenden Schicht 14 die untere Hauptoberfläche der zweiten Elektrodenschicht 16 berührt. Über der zweiten Elektrodenschicht 16 ist eine weitere isolierende Schicht 18 angeordnet, um die zweite Elektrodenschicht 16 zu schützen und elektrisch von der Umgebung zu isolieren. Der durch die Schichten 12, 14, 16 und 18 gebildete Schichtaufbau ist bei diesem Ausführungsbeispiel strukturiert, was beispielsweise mittels eines reaktiven Ionenätzens mittels einer Maske, die durch ein Druckverfahren aufgebracht wurde, erfolgen kann. Der Schichtaufbau weist somit an einem seitlichen Ende eine vertikale Seitenfläche 22 auf, die die Schichten des Schichtaufbaus seitlich begrenzen.

Der Transistor umfaßt ferner eine Kanalschicht, die sich entlang eines Teils der Oberfläche 10a, auf der seitlichen Oberfläche 22 des Schichtaufbaus aus den Schichten 12, 14, 16 und 18 und auf der oberen Hauptoberfläche der isolierenden Schicht 18 erstreckt. Die Kanalschicht 20 ist somit auf der seitlichen Oberfläche 22 mit der ersten und zweiten Elektrodenschicht 12 und 16 verbunden. Die Kanalschicht 20 ist ferner auf der seitlichen Oberfläche 22 mit der seitlichen Begrenzungsfläche 14a der isolierenden Schicht 14 verbunden, so daß eine Kanallänge der Kanalschicht 20 durch die Schichtdicke der isolierenden Schicht 14 gegeben ist. Obwohl sich bei diesem Ausführungsbeispiel die Kanalschicht 20 in dem Bereich der seitlichen Oberfläche 22 der Schichtstruktur vertikal bezüglich des Substrats 10 erstreckt, kann die seitliche Oberfläche 22 bei einem Ausführungsbeispiel mit einem Winkel, der kleiner als 90° ist, gegenüber der Hauptoberfläche 10a des Substrats 10 geneigt sein. Dies kann beispielsweise mittels eines anisotropen Ätzens erreicht werden, so daß die seitliche Oberfläche 22 die erforderliche Schräge aufweist.

Auf der Kanalschicht 20 ist eine Gateisolatorschicht 24 gebildet, die sich entsprechend zu der Kanalschicht 20 teilweise horizontal bezüglich des Substrats 10 und teilweise vertikal bezüglich des Substrats 10 erstreckt.

Ferner weist der Feldeffekttransistor eine Gateschicht 26 auf, die auf der Gateisolatorschicht 24 gebildet ist. Wie es in Fig. 2 zu erkennen ist, erstrecken sich die Schichten 20, 24 und 26 somit treppenförmig, wobei der Stufenabstand derselben jeweils durch die Dicke der Schichtanordnung aus den Schichten 12, 14, 16 und 18 festgelegt ist. Ferner sind die Schichten 20, 24 und 26 so strukturiert, daß sich dieselben lateral über den gleichen Bereich erstrecken.

Im folgenden wird nun ein Herstellungsprozeß zum Erzeugen des Feldeffekttransistors gemäß Fig. 1 näher erläutert.

Unter Bezugnahme auf Fig. 2 wird zunächst auf der Oberfläche 10a des Substrats 10 eine strukturierte Schicht 12' erzeugt, die die Sourceelektrode des Transistors darstellt. Daraufhin erfolgt die strukturierte Abscheidung der isolierenden Schicht 14', deren Dicke die Kanallänge des vertikalen Transistors definiert. Im weiteren wird zweite Elektrodenschicht 16' strukturiert abgeschieden und daraufhin die Isolationsschicht 18' auf der zweiten Elektrodenschicht 16' erzeugt. Nach dem Durchführen der obigen Verfahrensschritte ergibt sich die in Fig. 2 gezeigte Schichtanordnung, bei der durch die Schichten 12', 14', 16' und 18' eine strukturierte Schichtanordnung gebildet ist. In einem darauffolgenden Schritt erfolgt die eigentliche Erzeugung der Transistorkanalfläche mittels einer Ätzung der Schichten 12' bis 18', so daß sich die in Fig. 1 gezeigten struktureirten Schichten 12 bis 18. Durch das Strukturieren wird die seitliche Oberfläche 22 mittels der Ätzung gebildet.

Bei dem gezeigten Ausführungsbeispiel wird die gesamte Schichtanordnung geätzt, so daß sich die seitliche Oberfläche 22 als eine glatte Oberfläche von der isolierenden Schicht 18 zu dem Substrat 10 erstreckt. Bei einem weiteren Ausführungsbeispiel kann jedoch ein selektives Ätzen vorgesehen sein, so daß beispielsweise lediglich die oberen Schichten 14', 16' und 18' geätzt werden, wobei die untere Schicht 12' eine Stoppschicht für die Ätzung darstellt. Bei diesem Ausführungsbeispiel kann sich die Kanalschicht 22 auf einer Hauptoberfläche der nicht geätzten ersten Elektrodenschicht 12 erstrecken, so daß eine gute elektrische Verbindung der Kanalschicht mit der Elektrodenschicht 12 erreicht wird. Ebenso kann sich bei einem Ausführungsbeispiel die Kanalschicht 20 auf einer Hauptoberfläche der zweiten Elektrodenschicht 16 erstrecken, wobei die isolierende Schicht 18 entweder nicht gebildet wird oder nachträglich aufgebracht wird.

Nach der Strukturierung der Transistorfläche erfolgt die strukturierte Abscheidung des Halbleiters, der die Kanalschicht 20 bildet. Daraufhin wird der Gateisolator 24 und die Gateelektrodenschicht 26 abgeschieden. Bei dem gezeigten Ausführungsbeispiel werden die Schichten 20, 24 und 26 als strukturierte Schichten abgeschieden, d. h. daß vor dem Abscheiden eine Maske erzeugt wird, um die Schichten 20, 24 und 26 lediglich in einem durch die Maske definierten Bereich zu bilden. Ferner könnte eine nachträgliche Strukturierung der Schichten durchgeführt werden, wobei ein solches Verfahren die Herstellungskosten erhöht.

Das strukturierte Abscheiden der Schichten kann kostengünstig mittels bekannter Strukturierungsverfahren, wie beispielsweise Drucktechnologien, durchgeführt werden, da die Transistorparameter durch die Auflösung und Schwankungen der Genauigkeit der Drucktechnologie nicht beeinflußt werden. Die isolierenden Schichten 14 und 18 können mittels bekannter Druckverfahren aufgebracht werden. Ferner können die erste und zweite Elektrodenschicht mittels eines strukturierten Auflaminierens von einer Trägerfolie erzeugt werden. Der Halbleiter der Kanalschicht 20, der bei dem gezeigten Ausführungsbeispiel ein organisches Halbleitermaterial ist, kann wie die Gateisolatorschicht 24 mittels eines Druckverfahrens aufgebracht werden. Die Auftragung der Gateelektrode 26 kann wieder durch Auflaminierung von Schichten, wie beispielsweise Gold, Silber oder Aluminiumschichten erfolgen.

Bei einem weiteren Ausführungsbeispiel können die leitenden Schichten der ersten Elektrodenschicht 12, der zweiten Elektrodenschicht 16 und der Gateelektrode 8 durch ein organisches Material gebildet werden, so daß sich auch diese Schichten mittels eines Druckverfahrens aufbringen lassen. Die leitenden Schichten können beispielsweise leitende Polymere, beispielsweise Polyanilin, umfassen.

## Patentansprüche

1. Feldeffekttransistor mit folgenden Merkmalen:
einem Substrat (10) mit einer Hauptoberfläche (10a);
einer Drainschicht (16) und einer Sourceschicht (12), die sich in Richtung der Hauptoberfläche (10a) des Substrats (10) erstrecken und übereinander angeordnet sind;
einer isolierenden Schicht (14), die sich zwischen der Drainschicht (16) und der Sourceschicht (12) erstreckt;
einer Kanalschicht (20), die sich auf einer seitlichen Begrenzungsfläche (14a) der isolierenden Schicht (14) erstreckt und mit der Drainschicht (16) und der Sourceschicht (12) verbunden ist;
einer Gateisolatorschicht (24), die sich auf der Kanalschicht (20) erstreckt; und
einer auf der Gateisolatorschicht (24) angeordneten Gateschicht (26).

2. Feldeffekttransistor gemäß Anspruch 1, bei dem die Kanalschicht (20) ein organisches Halbleitermaterial aufweist.

3. Feldeffekttransistor gemäß Anspruch 1 oder 2, bei dem die Drainschicht (16) und/oder die Sourceschicht (12) ein organisches niedermolekulares Material umfassen.

4. Feldeffekttransistor gemäß einem der Ansprüche 1 bis 3, bei dem die Kanalschicht (20) ein polymeres Material umfaßt.

5. Feldeffekttransistor gemäß einem der Ansprüche 1 bis 4, bei dem sich die Kanalschicht (20) ferner auf einer seitlichen Begrenzungsfläche der Sourceschicht (12) und der Drainschicht (16) erstreckt.

6. Feldeffekttransistor gemäß einem der Ansprüche 1 bis 5, bei dem sich die Kanalschicht (20) ferner auf einer Oberfläche (10a) des Substrats (10) erstreckt.

7. Feldeffekttransistor gemäß einem der Ansprüche 1 bis 6, bei dem die seitliche Begrenzungsfläche (14a) der isolierenden Schicht (14) vertikal bezüglich des Substrats (10) ist.

8. Feldeffekttransistor gemäß einem der Ansprüche 1 bis 7, bei dem die seitliche Begrenzungsfläche (14a) der isolierenden Schicht (14) mit einem vorbestimmten Winkel gegenüber der Hauptoberfläche (10a) des Substrats (10) geneigt ist.

9. Verfahren zum Herstellen eines Feldeffekttransistors mit folgenden Schritten:
Bereitstellen eines Substrats (10) mit einer Hauptoberfläche (10a);
Erzeugen einer Drainschicht (16), einer Sourceschicht (12) und einer isolierenden Schicht (14), derart, daß sich dieselben in Richtung der Hauptoberfläche (10a) des Substrats (10) erstrecken und übereinander angeordnet sind, wobei sich die isolierende Schicht (14) zwischen der Drainschicht (16) und der Sourceschicht (12) erstreckt;
Erzeugen einer Kanalschicht, die sich auf einer seitlichen Begrenzungsfläche (14a) der isolierenden Schicht (14) erstreckt und mit der Drainschicht (16) und der Sourceschicht (12) verbunden ist;
Erzeugen einer Gateisolatorschicht (24), die sich auf der Kanalschicht (20) erstreckt; und
Erzeugen einer auf der Gateisolatorschicht (24) angeordneten Gateschicht (26).

10. Verfahren gemäß Anspruch 9, bei dem der Schritt des Erzeugens einer Drainschicht (16), einer Sourceschicht (12) und einer isolierenden Schicht (14) ein strukturiertes Abscheiden umfaßt.

11. Verfahren gemäß Anspruch 10, bei dem das strukturierte Abscheiden folgende Schritte umfaßt:
Erzeugen einer Maske zum Definieren von Maskenbereichen; und
Abscheiden der Drainschicht (16), der Sourceschicht (12) und der isolierenden Schicht (14) in dem Maskenbereich der Maske.

12. Verfahren gemäß Anspruch 11, bei dem das Erzeugen der Maske mittels eines Druckens erfolgt.

13. Verfahren gemäß einem der Ansprüche 9 bis 12, bei dem das Erzeugen der Drainschicht (16), der Sourceschicht (12) und der isolierenden Schicht (14) mittels eines Druckens erfolgt.

14. Verfahren gemäß einem der Ansprüche 9 bis 13, bei dem das Erzeugen der Kanalschicht (20) und/oder der Gateisolatorschicht (24) und/oder der Gateschicht (26) mittels eines Druckens erfolgt.

15. Verfahren gemäß einem der Ansprüche 9 bis 14, bei dem ferner ein Schritt des Ätzens der Drainschicht (16), der Sourceschicht (12) und der isolierenden Schicht (14) vorgesehen ist, um die seitliche Begrenzungsfläche (14a) der isolierenden Schicht (14) zu erzeugen.
